# EUROPEAN PATENT APPLICATION

(11) **EP 4 618 356 A1**
(43) Date of publication of application: **17.09.2025**
(21) Application number: 23888321.9
(22) Date of filing: 29.08.2023
(51) Int. Cl.: H02J 7/00, H01M 10/48, G01R 31/367, G01R 31/382, G01R 31/385, G01R 31/392, G01R 31/396

(54) **BATTERY MONITORING PROGRAM, RECORDING MEDIUM AND BATTERY MONITORING SYSTEM**

(30) Priority: 10.11.2022 JP 2022180267
(71) Applicant: DENSO CORPORATION, Kariya-city, Aichi-pref., 448-8661 (JP)
(72) Inventor: KUSANO, Yoshikazu, Kariya-city, Aichi-pref., 448-8661 (JP); YAMAMOTO, Nobuo, Kariya-city, Aichi-pref., 448-8661 (JP); MIZUNO, Yuki, Kariya-city, Aichi-pref., 448-8661 (JP); SHIBATA, Daisuke, Kariya-city, Aichi-pref., 448-8661 (JP); SUZUKI, Shogo, Kariya-city, Aichi-pref., 448-8661 (JP)
(74) Representative: Winter, Brandl - Partnerschaft mbB
(86) International application number: PCT/JP2023/031276
(87) International publication number: WO 2024/100966

(57) **Abstract**

A battery monitoring program (P1) is configured to cause at least one processor (1) to obtain a malfunction prediction sign of a secondary battery (2), and examine a battery characteristic of the secondary battery (2) on obtaining the malfunction prediction sign of the secondary battery (2). A battery monitoring system (2) to monitor a secondary battery (2) includes an examination unit (104) configured to examine a battery characteristic of the secondary battery (2) based on a malfunction prediction sign of the secondary battery (2) being obtained.

## Description

### CROSS REFERENCE TO RELATED APPLICATIONS

This application is based on Japanese Patent Application No. 2022-180267 filed on November 10, 2022, the disclosure of which is incorporated herein by reference.

### TECHNICAL FIELD

The present disclosure relates to techniques for monitoring a battery.

### BACKGROUND

Patent Literature 1 discloses a technique for managing multiple batteries arranged in an equipment replacement station. The technology aims to adjust a replacement priority of the multiple batteries. A battery management component according to the technique is configured to receive information indicative of at least one battery characteristic associated with batteries from a server, select at least one battery based on the at least one battery characteristic, and lower a replacement priority of the at least one battery based on the received information such that the at least one battery is removed later than the remaining batteries.

### PRIOR ART LITERATURE

### PATENT LITERATURE

Patent Literature 1: JP 2019-122253 A

### SUMMARY

The battery includes at least one cell. The at least one cell may be a secondary battery. The performance of a secondary battery deteriorates regardless of whether it is used or not. However, the performance of the secondary battery may rapidly deteriorate due to manufacturing variations and the influence of the environment around the secondary battery. However, the technique disclosed in Patent Literature 1 is not capable of detecting signs of deterioration in advance.

The present disclosure aims to provide a battery monitoring technique that is effective for preventing a secondary battery from failing.

According to an aspect of the present disclosure, a battery monitoring program is provided. The battery monitoring program is configured to cause at least one processor to acquire a malfunction prediction sign of a secondary battery and examine a battery characteristic of the secondary battery on obtaining the malfunction prediction sign.

According to another aspect of the present disclosure, a recording medium configured to store the battery monitoring program in a readable manner is provided.

According to yet another aspect of the present disclosure, a battery monitoring system to monitor a secondary battery is provided. The battery monitoring system includes an examination unit configured to examine a battery characteristic of the secondary battery based on a malfunction prediction sign being obtained.

According to each of the above-mentioned aspects, it is possible to prevent the secondary battery from falling.

The reference numerals in parentheses described in the claims indicate the correspondence relationship with the specific means described in the embodiments described later, and do not limit the technical scope of the present disclosure.

### BRIEF DESCRIPTION OF THE DRAWINGS

The above and other objects, features and advantages of the present disclosure will become more apparent from the following detailed description made with reference to the accompanying drawings. In the drawings:
FIG. 1 is a block diagram showing the configuration of a battery monitoring system according to a first embodiment;
FIG. 2 is a flowchart showing a battery monitoring control executed by a battery monitoring system of the first embodiment;
FIG. 3 is a conceptual diagram showing multiple pieces of monitoring data acquired by a monitoring data acquiring unit in FIG. 1;
FIG. 4 is a conceptual diagram showing a feature calculated by the monitoring data acquiring unit in FIG. 1;
FIG. 5 is a conceptual diagram of trend components of partial correlation coefficients in FIG. 4;
FIG. 6 is a conceptual diagram showing examination data obtained by an examination data acquiring unit in FIG. 1;
FIG. 7 is a block diagram showing the configuration of a battery monitoring system according to a second embodiment;
FIG. 8 is a block diagram showing the configuration of a battery monitoring system according to a third embodiment;
FIG. 9 is a block diagram showing the configuration of a battery monitoring system according to a fourth embodiment;
FIG. 10 is a block diagram showing the configuration of a battery monitoring system according to a fifth embodiment;
FIG. 11 is a block diagram showing the configuration of a battery monitoring system according to a sixth embodiment;
FIG. 12 is a block diagram showing the configuration of a battery monitoring system according to a seventh embodiment;
FIG. 13 is a block diagram showing the configuration of a battery monitoring system according to an eighth embodiment;
FIG. 14 is a block diagram showing the configuration of a battery monitoring system according to a ninth embodiment; and
FIG. 15 is a block diagram showing the configuration of a battery monitoring system including a display program.

### DESCRIPTION OF EMBODIMENTS

Hereinafter, a battery monitoring technology according to the above-mentioned embodiments will be described in detail with reference to the drawings.

### (First embodiment)

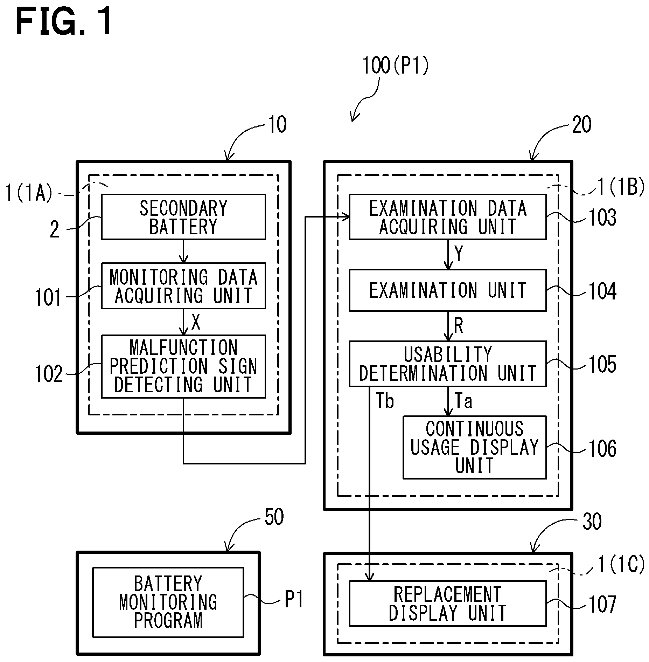

As shown in FIG. 1, a battery monitoring system 100 according to the first embodiment is a system to monitor a secondary battery 2 constituting a battery mounted on a vehicle 10 such as an electric vehicle or a hybrid vehicle. The secondary battery 2 is a battery assembly formed of multiple battery cells. The secondary battery 2, together with a Battery Management Unit (i.e., BMU), forms a so-called "battery pack," and the BMU includes a monitoring data acquiring unit 101 and a malfunction prediction sign detecting unit 102, which will be described later. The secondary battery 2 (i.e., the battery pack) may be of a replaceable type (cartridge type) that is removably mounted on the vehicle 10, or may be of a fixed type that is non-removably mounted on the vehicle 10.

The battery monitoring system 100 has as its components the monitoring data acquiring unit 101, the malfunction prediction sign detecting unit 102, an examination data acquiring unit 103, an examination unit 104, a usability determination unit 105, a continuous usage display unit 106, and a replacement display unit 107. The functions of these components are executed by processors 1 (processors 1A, 1B, 1C) provided in a battery pack of the vehicle 10, a charging station 20, and a battery service center, respectively.

The charging station 20 is a facility where at least charging operation of the secondary battery 2 mounted on the vehicle 10 is performed. In the charging station 20, the secondary battery 2 may be charged with being mounted on the vehicle 10, or with being removed from the vehicle 10. The secondary battery 2 having been charged may be used again in the vehicle 10, or in another vehicle, or may be reused in a secondary usage destination other than the vehicle 10.

The battery service center 30 is a facility where broken secondary batteries 2 are replaced with new secondary batteries. The battery service center 30 may be installed adjacent to the charging station 20 or may be installed at a location away from the charging station 20.

The functions of each component of the battery monitoring system 100 are realized by a battery monitoring program P1. The battery monitoring program P1 is a program configured to cause the processors 1 to realize at least the following functions: acquiring monitoring data X of the secondary battery 2; detecting a malfunction prediction sign of the secondary battery 2 based on the acquired monitoring data X; examining the battery characteristic of the secondary battery 2 when the malfunction prediction sign of the secondary battery 2 is obtained; and determining whether the secondary battery 2 is usable based on an examination result R of the battery characteristic. The battery monitoring program P1 is preferably recorded on a recording medium 50 in a readable manner as necessary. The "recording" here can also be called "storage." As the recording medium 50, various types such as a memory type, a disk type, and a tape type may be used.

In the drawings, the recording medium 50 is illustrated separately from the vehicle 10, the charging station 20, the battery service center 30, and a battery monitoring server 40, which will be described later. However, the recording medium 50 is included in at least one of these components. In the drawings, the recording medium 50 is shown separately from the above-mentioned components in order to avoid complicated or limited representation of the recording location of the battery monitoring program P1.

The "processor 1" referred to here broadly includes processing devices, among components of a computer, that perform operations such as data calculations and conversions, program execution, and control of other devices. Typically, the processor 1 is composed of a Central Processing Unit (i.e., CPU), which controls the entire computer, or a Micro Processing unit (i.e., MPU), which integrates some of the functions of the CPU.

In this embodiment, the processor 1A mounted on the BMU of the battery pack executes each function of the monitoring data acquiring unit 101 and the malfunction prediction sign detecting unit 102. The processor 1B mounted on a management server (not shown) of the charging station 20 executes each function of the examination data acquiring unit 103, the examination unit 104, the usability determination unit 105, and the continuous usage display unit 106. The processor 1C mounted on a management server (not shown) of the battery service center 30 executes the function of the replacement display unit 107.

The allocation of the multiple components (functional elements) of the battery monitoring system 100 among the vehicle 10, the charging station 20, and the battery service center is not limited to that shown in FIG. 1, and can be changed appropriately as necessary.

The monitoring data acquiring unit 101 has a function of acquiring monitoring data X of the secondary battery 2. The monitoring data X may be sensed directly from the secondary battery 2, or may be data converted as history information from the sensed data by a control unit or the like. As the monitoring data X, time series data of voltage, charge/discharge current, State of Charge (i.e., SOC: charging state), battery temperature, ambient temperature around the battery, cumulative charging time, cumulative discharging time, cumulative current, and the like may be used. Furthermore, as the monitoring data for the battery assembly, time-series data of the total voltage of the battery assembly, the maximum and/or minimum voltage, temperature, and the SOC of the secondary batteries in the battery assembly may be used. The "voltage" here includes open circuit voltage and closed circuit voltage. The monitoring data acquiring unit 101 may be a sensor capable of detecting the monitoring data X to be acquired, such as a voltage sensor, a current sensor, and a temperature sensor, and the SOC is calculated based on these values.

The malfunction prediction sign detecting unit 102 has a function of detecting a malfunction prediction sign of the secondary battery 2 based on the monitoring data X acquired by the monitoring data acquiring unit 101. The examination data acquiring unit 103 has a function of acquiring examination data Y used for examination of a battery characteristic of the secondary battery 2. The examination data may be sensed directly from the secondary battery 2, or may be data converted as history information from the sensed data by a control unit or the like. As the examination data Y, it is preferable to use, for example, data included in the results of charging and discharging the secondary battery 2 under specified conditions (constant current charging and discharging, pulse charging and pulse discharging, etc.). The charging under the specified conditions may be performed in the charging station 20, or the results of charging and discharging under the specified conditions may be extracted from charging and discharging result while the secondary battery 2 is in operation. Additionally, a constant current pattern is easily obtained when driving at a stable speed on a highway, controlling the temperature or powering electrical equipment while the vehicle is stopped, and in stationary use such as V2H (a system known as "vehicle to home"). Furthermore, pulse charging and pulse discharging are easily obtained in regeneration during braking and output when starting.

The examination unit 104 has a function of examining the battery characteristic of the secondary battery 2 on the condition that a malfunction prediction sign of the secondary battery 2 is obtained from the vehicle 10 (i.e., the malfunction prediction sign detecting unit 102 detects a malfunction prediction sign of the secondary battery 2). The "battery characteristic" referred to here typically includes the capacity, internal resistance, charge/discharge efficiency, self-discharge amount, cycle life, and the like of the secondary battery 2. The usability determination unit 105 has a function of determining whether the secondary battery 2 is usable or not based on the examination result R of the battery characteristic examined by the examination unit 104, and a function of notifying the continuous usage display unit 106 and the replacement display unit 107 of the determination results Ta, Tb.

The continuous usage display unit 106 has a function of displaying the determination result Ta notified by the usability determination unit 105. The determination result Ta indicates that the secondary battery 2 is suitable for continued use. The replacement display unit 107 has a function of displaying the determination result Tb notified by the usability determination unit 105. The determination result Tb indicates that the secondary battery 2 is not suitable for continued use and requires replacement. The determination results Ta and Tb are preferably displayed on the screen of a device, such as a desktop or notebook personal computer (i.e., PC), a tablet terminal, or a mobile terminal.

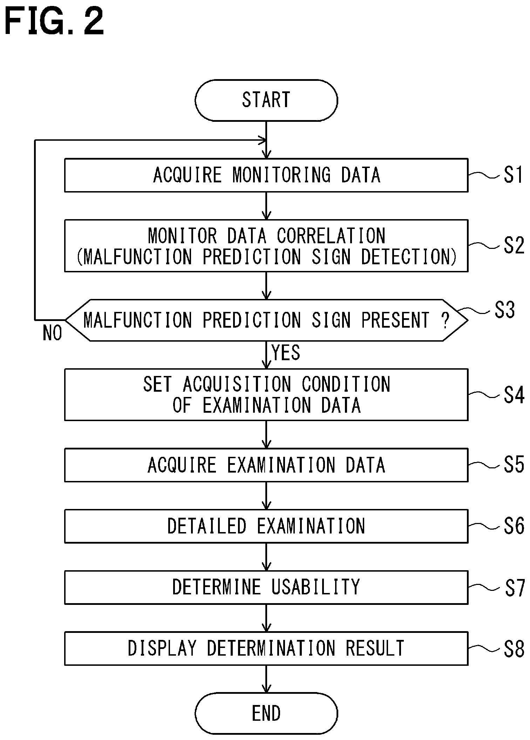

Next, the battery monitoring control by the battery monitoring system 100 will be described with reference to FIGS. 2 to 5. The battery monitoring control is achieved by sequentially executing steps S1 to S8 in FIG. 2. It should be noted that one or more steps may be added to these steps as necessary, or multiple steps may be appropriately integrated.

As shown in FIG. 2, step S1 is a step in which the monitoring data acquiring unit 101 (see FIG. 1) acquires monitoring data X of the secondary battery 2. According to step S1, monitoring data X of the secondary battery 2 is acquired. Step S2 is a step in which the malfunction prediction sign detecting unit 102 (see FIG. 1) monitors data correlation of the monitoring data X acquired in step S1. According to step S2, data correlation of the monitoring data X is monitored. Step S3 is a step in which the malfunction prediction sign detecting unit 102 (see FIG. 1) determines whether there is a malfunction prediction sign of the secondary battery 2 based on the monitoring result in step S2. If it is determined in step S3 that there is a malfunction prediction sign of the secondary battery 2 ("Yes" in step S3), the control proceeds to step S4. If it is determined that there is not a malfunction prediction sign ("No" in step S3), the control returns to step S1.

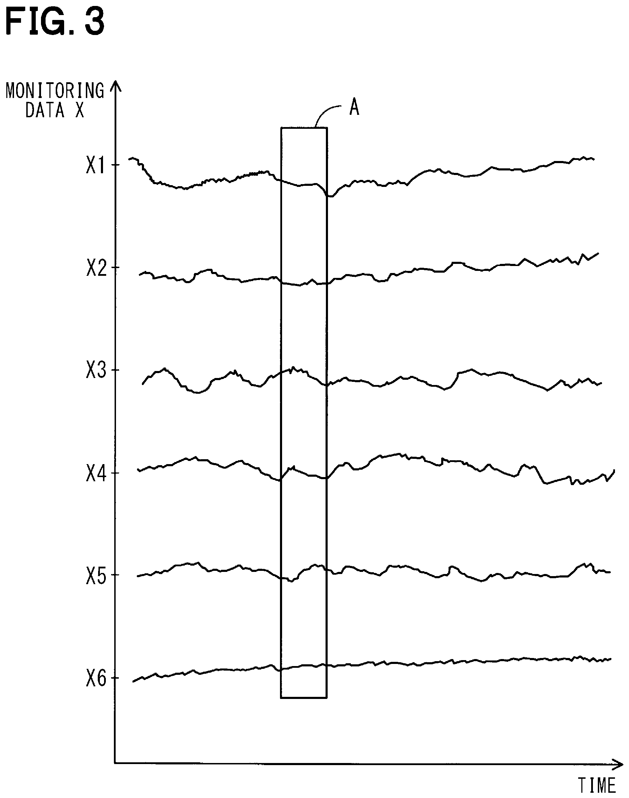

Here, a specific example of the process from step S1 to step S3 will be described with reference to FIGS. 3 to 6.

As shown in FIG. 3, in step S1, a feature of the secondary battery 2 is calculated using multiple types of the monitoring data X (six types of monitoring data X1 to X6 in FIG. 3). The feature may be a correlation coefficient between variables of the multiple types of the monitoring data X. In this embodiment, the correlation coefficient is calculated as a partial correlation coefficient between the explanatory variables and the objective variable from the components of the inverse covariance matrix of the monitoring data X. The inverse covariance matrix can be calculated by performing sparse regularization using multiple types of the monitoring data X as variables. The number of types of the monitoring data X is not limited to six.

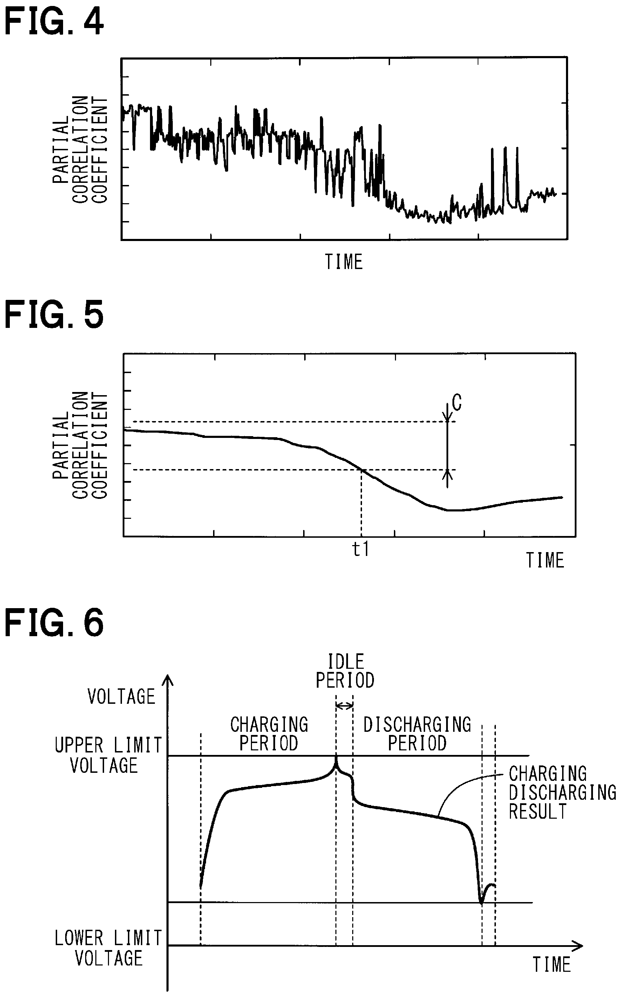

In this embodiment, first, sparse regularization is performed using the monitoring data X1 to X6 acquired in the first period A as variables, and a partial correlation coefficient matrix is calculated as an inverse covariance matrix. Then, a partial correlation coefficient (see FIG. 4), which is a specific component of the partial correlation coefficient matrix, is calculated as a feature. As shown in FIG. 4, the partial correlation coefficient as a feature changes over time.

It should be noted that the terms "sparse regularization" and "partial correlation coefficient" used here are well-known terms defined in multivariate analysis, which is a method of finding associations between variables by generally grouping similar variables from among many variables. For further details of this multivariable analysis, reference can be made to, for example, "failure diagnosis" disclosed in JP 2019-152656 and "the amount of Influence estimation processing" disclosed in JP 2020-135591.

Next, in step S2, as shown in FIG. 5, a trend component is extracted as systematic fluctuations of the feature by factor decomposition in time series analysis or by smoothing processing. Factor decomposition in time series analysis can be performed by a known method. As the smoothing process, a moving average that calculates an average of the most recent amount of the feature, or Kalman smoothing that extracts past systematic fluctuations based on the amount of the feature up to the present may be used. The period of the feature used to extract the systematic variation is not particularly limited.

Regarding the cycle of fluctuation of the feature, for example, when monitoring with a focus on seasonal changes over a year, the fluctuation component with a cycle of one year is regarded as a seasonal fluctuation component, and the fluctuation component with a cycle longer than one year is regarded as a long-period trend component. In addition, the fluctuation component with a cycle shorter than seasonal fluctuations ia defined as a random fluctuation. In addition, when monitoring changes in usage over a one-week period, the fluctuation component with a one-week cycle is defined as a weekly fluctuation component, the fluctuation component with a cycle longer than one week as a long-cycle trend component, and the fluctuation component with a cycle shorter than one week as a random fluctuation.

Here, it is known that a malfunction prediction sign of the secondary battery 2 appears as a long-period trend component in the partial correlation coefficient. Thus, extraction of a trend component from the partial correlation coefficient as a systematic variation makes a long-period trend component that reflects an abnormality in the secondary battery 2 apparent.

Thus, in step S3, it is determined whether the systematic fluctuation of the trend component in FIG. 5 deviates from a predetermined reference range C (that is, whether a breakdown in correlation is observed). In this embodiment, the reference range C is predetermined when the secondary battery 2 is designed, based on the fluctuation range of systematic fluctuations in bench evaluation. If it is determined that the systematic variation is outside the reference range C, it is determined in step S3 that "there is a malfunction prediction sign". As shown in FIG. 5, at time t1, the trend component, which is a systematic variation, deviates from the reference range C, and it is determined that there is a malfunction prediction sign of the secondary battery 2.

Further details of the processing from step S1 to step S3 in this embodiment can be clarified, for example, by referring to the battery monitoring system and its control disclosed in JP 2021-135114 A.

As shown in FIG. 2, step S4 is a step in which the examination data acquiring unit 103 (see FIG. 1) sets acquisition condition of the examination data Y of the secondary battery 2. According to step S4, the acquisition conditions for the examination data Y of the secondary battery 2 are set. The acquisition conditions may include the acquisition period of the examination data Y, the items of the examination data Y to be acquired, the number of acquisitions (such as the number of acquired cells), and the transmission period of the acquired examination data Y to the examination unit 104. When a preset acquisition condition is used, step S4 can be omitted.

The above acquisition conditions preferably ensure that more detailed examination data Y is transmitted to the examination unit 104 compared to when the vehicle 10 is normally driven. The above condition is achieved, for example, by shortening the acquisition period of the examination data Y, increasing the number of items and pieces of the examination data Y, or shortening the transmission period of the examination data Y to the examination unit 104. This allows the examination unit 104 to examine the battery characteristic of the secondary battery 2 in detail. For example, if the examination data Y contains voltage, only the upper and lower limit voltages of the secondary battery 2 are used for control during normal driving. However, the amount of data is increased by acquiring the voltage fluctuation values for all cells of the secondary battery 2. Similarly, if the examination data Y contains temperature, only the upper and lower limit temperatures of the secondary battery 2 are used for control during normal driving. However, the amount of data is increased by acquiring the temperature fluctuation values for all cells of the secondary battery 2.

Step S5 is a step in which the examination data acquiring unit 103 (see FIG. 1) acquires the examination data Y of the secondary battery 2. FIG. 6 shows an example where the charging discharging results of the secondary battery 2 are acquired as the examination data Y in step S5 of the present embodiment. The charging discharging results are preferably obtained during constant current charging and discharging of the secondary battery 2. In the charging discharging results, there is a discharging period following the charging period with the idle period in between. It should be noted that the charging discharging results are merely illustrative and are not limited to the charging discharging results. For example, the charging and discharging result may be obtained as a charging and discharging pattern in which pulse charging and discharging are repeated while gradually changing the current.

Step S6 in FIG. 2 is a step in which the examination unit 104 (see FIG. 1) performs a detailed examination of the battery characteristic of the secondary battery 2 based on the examination data Y acquired in step S5. According to step S6, the battery characteristic of the secondary battery 2 is examined in detail. When the charging discharging results of the secondary battery 2 are obtained as the examination data Y, the battery characteristics of the secondary battery 2, such as the capacity, internal resistance, charge/discharge efficiency, self-discharge amount, and cycle life, are examined based on the obtained charging and discharging results.

In this embodiment, since the examination unit 104 is provided in the charging station 20 (see FIG. 1) to execute step S6, it is possible to manipulate the charging and discharging pattern of the examination data Y, thereby enabling more accurate detailed examination. Additionally, this is effective in efficiently performing correction and updating of the examination logic for detailed examination at the charging station 20.

Step S7 following step S6 is a step in which the usability determination unit 105 (see FIG. 1) determines whether the secondary battery 2 is usable or not. In step S7, a threshold is set for the result of the detailed examination in step S6, and the usability of the secondary battery 2 is determined based on the threshold. In this case, the threshold value may be preset, or may be updated by a system administrator during use. In step S7, it is determined whether the secondary battery 2 is suitable for continued use or requires replacement.

Step S8 is a step of displaying the determination result in step S7 by the continuous usage display unit 106 and the replacement display unit 107 (see FIG. 1). According to step S8, the continuous usage display unit 106 displays a determination result Ta indicating that the secondary battery 2 is suitable for continued use. In this embodiment, the continuous usage display unit 106 is provided in the charging station 20, so that if the battery pack including the secondary battery 2 is replaceable, the determination result Ta of the battery pack on loan can be confirmed at the charging station 20. Furthermore, according to step S8, the replacement display unit 107 displays a determination result Tb indicating that the secondary battery 2 is not suitable for continued use and requires replacement. In this embodiment, the replacement display unit 107 is provided in the battery service center 30, so that the battery service center 30 can quickly proceed to preparations for the replacement of the secondary battery 2 after confirming the determination result Tb, thereby shortening the waiting time for the replacement of the secondary battery 2. As a result, the efficiency of maintenance work for the secondary battery 2 can be improved.

According to the first embodiment, the following effects are obtained.

In the first embodiment, a process of examining the battery characteristics of the secondary battery 2 is executed when a malfunction prediction sign of the secondary battery 2 is obtained. This makes it possible to prevent the secondary battery 2 from failing. For example, if there is a sign of a sudden deterioration in performance of the secondary battery 2 that may lead to failure, the secondary battery showing the sign is examined in detail, thereby preventing the secondary battery 2 from failing while in use.

Furthermore, in the first embodiment, the battery characteristic of the secondary battery 2 is examined only when a malfunction prediction sign of the secondary battery 2 is acquired. Thus, unnecessary examinations such as periodic examinations can be omitted, and the operating efficiency of the secondary battery 2 can be improved accordingly.

Furthermore, in the first embodiment, it is determined whether the secondary battery 2 is usable based on the examination result R of the battery characteristic of the secondary battery 2. Thus, the accuracy of determination as to whether the secondary battery 2 is usable or not can be improved.

In the first embodiment, if the malfunction prediction sign detecting unit 102 (step S3) determines that there is a malfunction prediction sign in the secondary battery 2, notification information may be displayed on a display unit (not shown) of the vehicle 10. Examples of the "notification information" referred to here include a malfunction prediction sign notification indicating that there is a malfunction prediction sign in the secondary battery 2 and a return encouragement notification that encourages the return of the secondary battery 2. As a result, the occupant who has confirmed the notification information will take action to move the vehicle 10 to the charging station 20 or the like. As a result, the risk of failure of the secondary battery 2 while the vehicle 10 is moving can be reduced.

Hereinafter, other embodiments related to the above-described first embodiment will be described with reference to the drawings. In other embodiments, the same elements as those in the first embodiment are denoted by the same reference numerals, and the description of the same elements is omitted.

### (Second Embodiment)

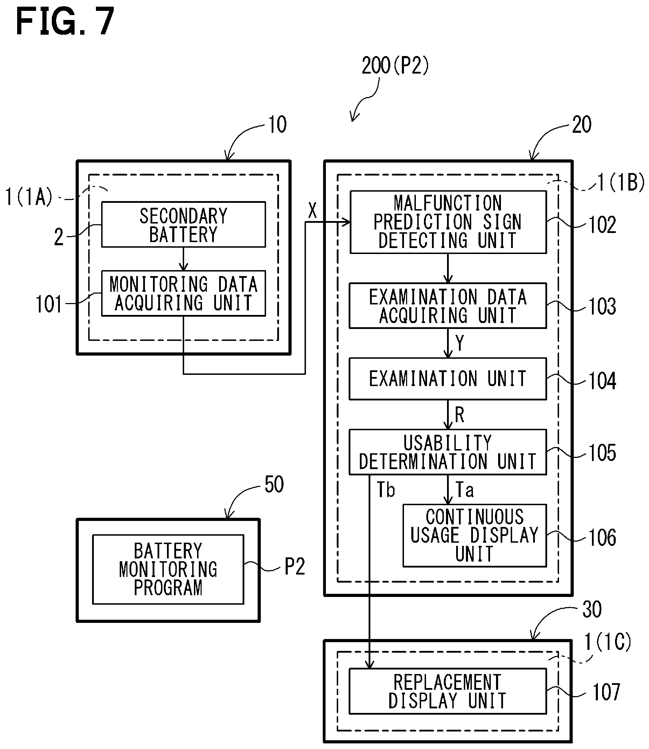

As shown in FIG. 7, a battery monitoring system 200 of the second embodiment differs from the battery monitoring system 100 of the first embodiment in that the malfunction prediction sign detecting unit 102 is provided in the charging station 20 instead of the battery pack of the vehicle 10. In the battery monitoring system 200, the monitoring data X acquired by the monitoring data acquiring unit 101 may be temporarily stored by a data storage function provided in the battery pack of the vehicle 10, and then output to the charging station 20 when the vehicle 10 or the battery pack arrives at the charging station 20. Alternatively, the monitoring data X may be constantly output to the charging station 20 by a data transmission/reception function between the vehicle 10 and the charging station 20. The functions of each component of the battery monitoring system 200 are realized by a battery monitoring program P2. The battery monitoring program P2 is a program configured to cause the processors 1 (processors 1A, 1B, 1C) to realize functions similar to those of the battery monitoring program P1 of the first embodiment. The battery monitoring program P2 is preferably recorded on the recording medium 50 in a readable manner as necessary.

The other configuration is the same as that of the first embodiment.

According to the second embodiment, both the process of detecting a malfunction prediction sign of the secondary battery 2 based on the monitoring data X and the process of examining the battery characteristic of the secondary battery 2 in detail based on the examination data Y are collectively performed in the charging station 20. This is effective for efficiently performing correction and updating of the detection logic for a malfunction prediction sign, and correction and updating of the examination logic for detailed examination at the charging station 20. Furthermore, according to the second embodiment, the function of the malfunction prediction sign detecting unit 102 is transferred to the charging station 20, thereby reducing the calculation load of the BMU in the battery pack.

In addition, this embodiment has the same functions and advantages as in the first embodiment.

### (Third Embodiment)

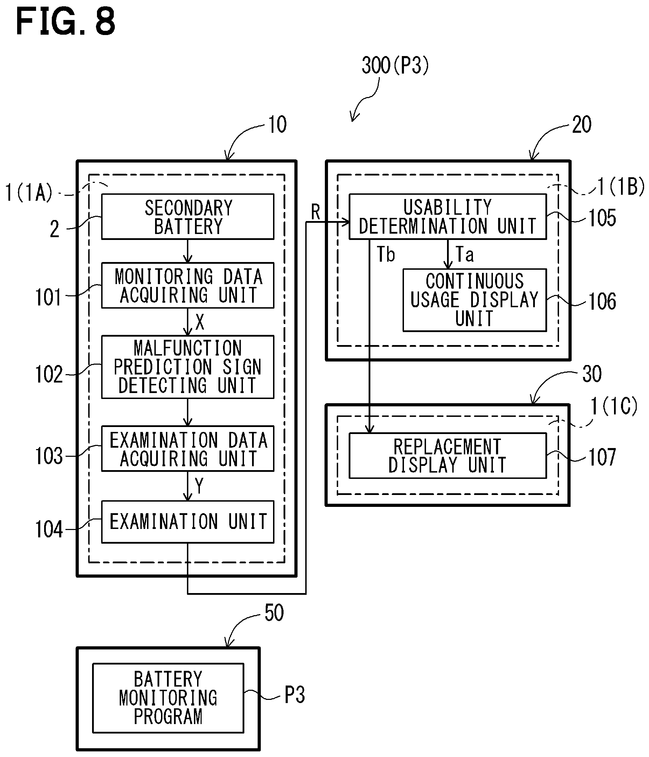

As shown in FIG. 8, a battery monitoring system 300 of the third embodiment differs from the battery monitoring system 100 of the first embodiment in that the examination data acquiring unit 103 and the examination unit 104 are provided in the battery pack of the vehicle 10 instead of the charging station 20. The function of each component of the battery monitoring system 300 are realized by a battery monitoring program P3. The battery monitoring program P3 is a program configured to cause the processors 1 (processors 1A, 1B, 1C) to realize functions similar to those of the battery monitoring program P1 of the first embodiment. The battery monitoring program P9 is preferably recorded on the recording medium 50 in a readable manner as necessary.

The other configuration is the same as that of the first embodiment.

According to the third embodiment, both the process of detecting a malfunction prediction sign of the secondary battery 2 based on the examination data Y and the process of examining the battery characteristic of the secondary battery 2 in detail based on the examination data Y are collectively performed in the vehicle 10. This is effective for efficiently performing correction and updating of the detection logic for a malfunction prediction sign, and correction and updating of the examination logic for detailed examination in the vehicle 10. In addition, according to the third embodiment, the functions of the examination data acquiring unit 103 and the examination unit 104 are transferred to the battery pack in the vehicle 10. This allows for a quick transition to a detailed examination after detecting a malfunction prediction sign of the secondary battery 2.

In addition, this embodiment has the same functions and advantages as in the first embodiment.

### (Fourth Embodiment)

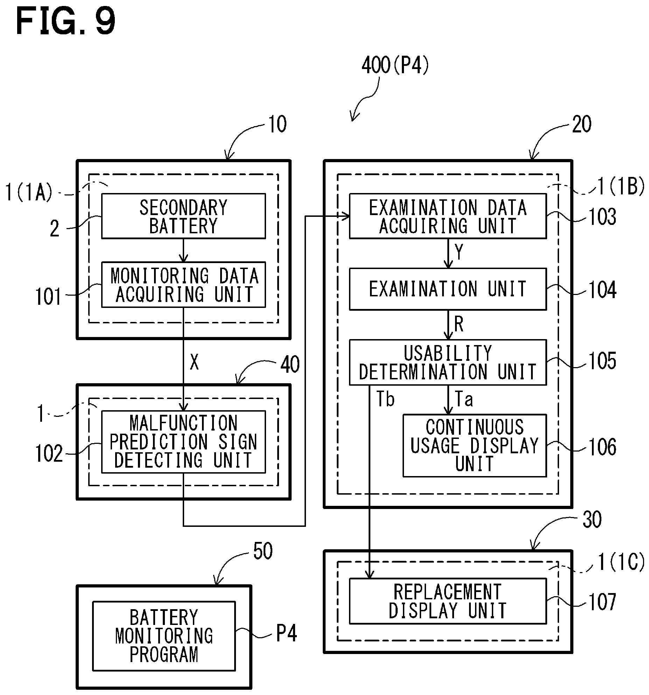

As shown in FIG. 9, a battery monitoring system 400 of the fourth embodiment differs from the battery monitoring system 100 of the first embodiment in that the malfunction prediction sign detecting unit 102 is provided in the battery monitoring server 40 instead of the battery pack of the vehicle 10. The battery monitoring server 40 is a facility for providing a monitoring service for the secondary battery 2. In the battery monitoring system 400, when a malfunction prediction sign is detected by the malfunction prediction sign detecting unit 102 in the battery monitoring server 40, the charging station 20 is notified of the detection. Thereafter, when the vehicle 10 or the battery pack arrives at the charging station 20, the examination data acquiring unit 103 in the charging station 20 acquires the examination data Y. The processor 1D mounted on the battery monitoring server 40 executes the function of the malfunction prediction sign detecting unit 102. The battery monitoring server 40 may be provided in either the charging station 20 or the battery service center 30, or may be provided in a location away from the charging station 20 or the battery service center 30. The function of each component of the battery monitoring system 400 is realized by a battery monitoring program P4. The battery monitoring program P4 is a program configured to cause the processors 1 (processors 1A, 1B, 1C, 1D) provided respectively in the battery pack in the vehicle 10, the charging station 20, the battery service center 30, and the battery monitoring server 40 to realize functions similar to those of the battery monitoring program P1 of the first embodiment. The battery monitoring program P4 is preferably recorded on the recording medium 50 in a readable manner as necessary.

The other configuration is the same as that of the first embodiment.

According to the fourth embodiment, the battery monitoring server 40 can perform a process of detecting a malfunction prediction sign of the secondary battery 2 based on the monitoring data X. This is effective for efficiently performing correction and updating of the detection logic for a malfunction prediction sign in the battery monitoring server 40.

In addition, this embodiment has the same functions and advantages as in the first embodiment.

### (Fifth Embodiment)

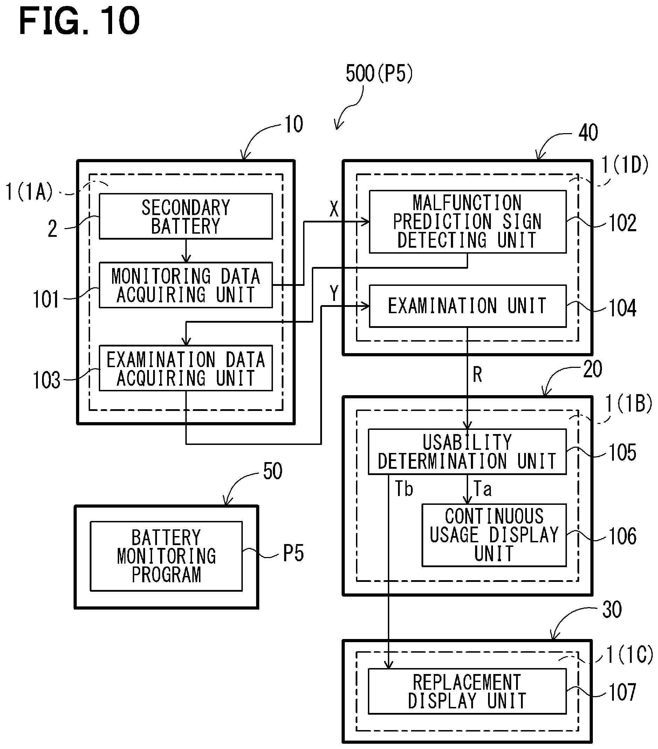

As shown in FIG. 10, a battery monitoring system 500 of the fifth embodiment differs from the battery monitoring system 400 of the fourth embodiment in that the examination data acquiring unit 103 is provided in the battery pack of the vehicle 10 instead of the charging station 20, and the examination unit 104 is provided in the battery monitoring server 40 instead of the charging station 20. The function of each component of the battery monitoring system 500 is realized by a battery monitoring program P5. The battery monitoring program P5 is a program configured to cause the processors 1 (processors 1A, 1B, 1C, 1D) to realize functions similar to those of the battery monitoring program P4 of the fourth embodiment. The battery monitoring program P5 is preferably recorded on the recording medium 50 in a readable manner as necessary.

The other configurations and the control are the same as those of the fourth embodiment.

According to the fifth embodiment, the battery monitoring server 40 collectively executes both the process of detecting a malfunction prediction sign of the secondary battery 2 based on the monitoring data X and the process of examining the battery characteristic of the secondary battery 2 based on the examination data Y. This is effective for efficiently performing correction and updating of the detection logic for malfunction prediction signs, and correction and updating of the examination logic for detailed examination in the battery monitoring server 40.

In addition, this embodiment has the same functions and advantages as in the fourth embodiment.

As a modification particularly related to the battery monitoring system 500 of the fifth embodiment, a battery monitoring system in which the battery monitoring server 40 includes a usability determination unit 105 may be adopted.

### (Sixth Embodiment)

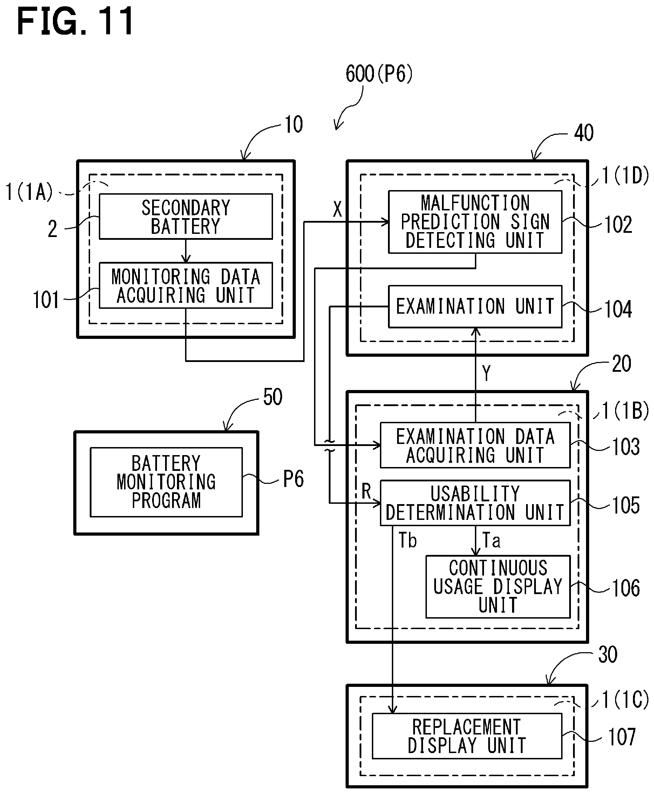

As shown in FIG. 11, a battery monitoring system 600 of the sixth embodiment differs from the battery monitoring system 500 of the fifth embodiment in that the examination data acquiring unit 103 is provided in the charging station 20 instead of the battery pack of the vehicle 10. The function of each component of the battery monitoring system 600 is realized by a battery monitoring program P6. The battery monitoring program P6 is a program configured to cause the processors 1 (processors 1A, 1B, 1C, 1D) to realize functions similar to those of the battery monitoring program P5 of the fifth embodiment. The battery monitoring program P6 is preferably recorded on the recording medium 50 in a readable manner as necessary.

The other configurations and the control are similar to those of the fifth embodiment.

According to the sixth embodiment, the process of acquiring the examination data Y can be performed in the charging station 20. In this case, the intended charging and discharging pattern can be obtained at the charging station 20, which is effective in improving the examination accuracy. In addition, this is effective in efficiently performing correction and updating of the acquisition conditions of the examination data Y at the charging station 20.

In addition, this embodiment has the same functions and advantages as in the fifth embodiment.

### (Seventh Embodiment)

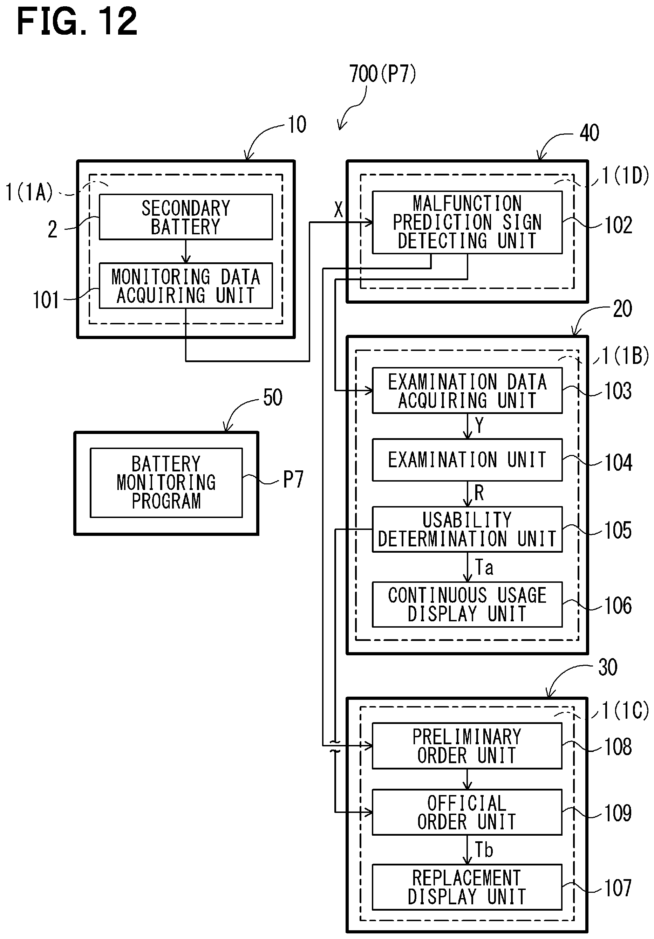

As shown in FIG. 12, a battery monitoring system 700 of the seventh embodiment differs from the battery monitoring system 600 of the sixth embodiment in that the examination unit 104 is provided in the charging station 20 instead of the battery monitoring server 40, and in that the battery service center 30 further includes a preliminary order unit 108 and a formal order unit 109. The function of each component of the battery monitoring system 700 is realized by a battery monitoring program P7. The battery monitoring program P7 is a program configured to cause the processors 1 (processors 1A, 1B, 1C, 1D) to realize a function of instructing placement of a preliminary order of a replacement secondary battery to replace the secondary battery when a malfunction prediction sign of the secondary battery 2 is obtained and a function of instructing placement of an official order of the replacement secondary battery when it is determined that the secondary battery 2 is not usable based on the examination result R of the battery characteristic, in addition to the functions similar to those of the battery monitoring program P6 of the sixth embodiment. The battery monitoring program P7 is preferably recorded on the recording medium 50 in a readable manner as necessary.

The preliminary order unit 108 has the function of instructing placement of a preliminary order for a replacement secondary battery 2 to replace the secondary battery 2 when the malfunction prediction sign detecting unit 102 obtains a malfunction prediction sign of the secondary battery 2. Thereby, a replacement secondary battery is preliminarily ordered. The official order unit 109 has the function of instructing placement of an official order for the replacement secondary battery when the usability determination unit 105 determines that the secondary battery 2 is unusable based on the examination result R of the battery characteristic examined by the examination unit 104, i.e., on the condition that the determination result Tb is obtained. As a result, the replacement secondary battery that has already been preliminarily ordered is officially ordered. Moreover, the formal order unit 109 is configured to display the determination result Tb that is made by the usability determination unit 105 on a replacement display unit 107.

The other configurations and the controls are the same as those of the sixth embodiment.

According to the seventh embodiment, a preliminary order for the secondary battery 2 is placed based on the examination result R of the battery characteristic by the examination unit 104, and the preliminary order for the secondary battery 2 is switched to a formal order by the formal ordering unit 109 upon receipt of the determination result Tb. This allows the battery service center 30 to quickly move on to preparations for the replacement of the secondary battery 2, and also shortens the time spent waiting for the delivery of the secondary battery 2. As a result, the efficiency of maintenance work for the secondary battery 2 can be improved.

In addition, this embodiment has the same functions and advantages as in the sixth embodiment.

### (Eighth Embodiment)

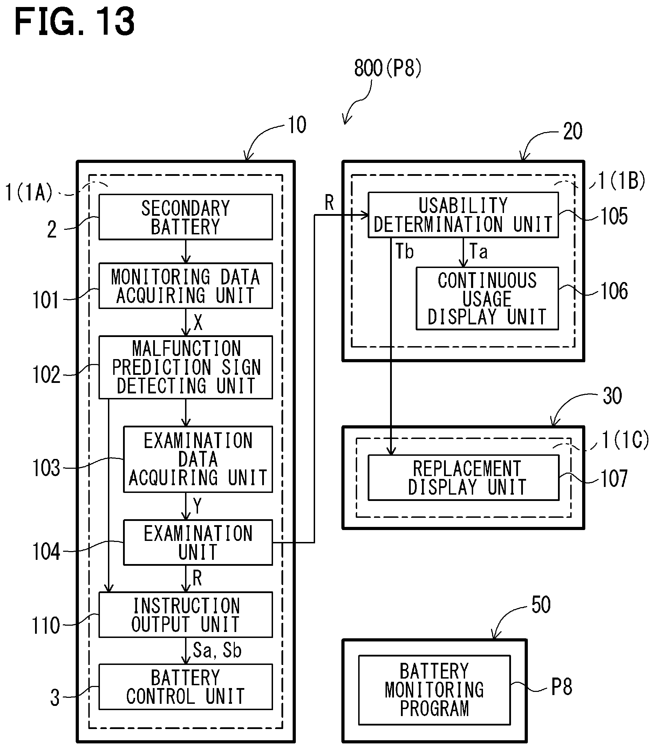

As shown in FIG. 13, a battery monitoring system 800 of the eighth embodiment differs from the battery monitoring system 100 of the first embodiment in that the malfunction prediction sign detecting unit 102 and the examination data acquiring unit 103 are provided in the battery pack in the vehicle 10 instead of the charging station 20, and in that the battery pack of the vehicle 10 further includes an instruction output unit 110. The function of each component of the battery monitoring system 800 is realized by a battery monitoring program P8. The battery monitoring program P8 is a program configured to cause the processor 1 (processors 1A, 1B, 1C) to realize a function of outputting a usage restriction instruction Sa to a battery controller 3 when a malfunction prediction sign of the secondary battery 2 is obtained and a function of outputting a usage restriction lift instruction Sb to the battery controller 3 when the secondary battery 2 is normal based on the examination result R of the battery characteristic, in addition to the functions similar to those of the battery monitoring program P1 of the first embodiment. The battery monitoring program P8 is preferably recorded on the recording medium 50 in a readable manner as necessary.

The instruction output unit 110 has both the function of outputting the usage restriction instruction Sa to the battery controller 3 when the malfunction prediction sign detecting unit 102 obtains a malfunction prediction sign of the secondary battery 2, and the function of outputting the usage restriction lift instruction Sb to the battery controller 3 when the secondary battery 2 is normal based on the examination result R of the battery characteristic made by the examination unit 104. The battery controller 3 performs control on the secondary battery 2 with usage restrictions on the normal control of the secondary battery 2 upon receiving the usage restriction instruction Sa from the instruction output unit 110. On the other hand, the battery controller 3 performs normal control on the secondary battery 2 without the usage restriction upon receiving the usage restriction lift instruction Sb from the instruction output unit 110. The "usage restrictions" referred to here include limiting input/output power, narrowing the upper and lower voltage ranges, improving battery temperature adjustment performance, and controlling the battery to prevent further deterioration. The battery controller 3 may be a battery controller originally provided in the secondary battery 2, or may be provided exclusively for the instruction output unit 110.

The other configuration is the same as that of the first embodiment.

According to the eighth embodiment, the usage restriction is imposed on the secondary battery 2 when there is a malfunction prediction sign, thereby reducing the risk of a malfunction in the secondary battery 2 occurring while the vehicle 10 is moving. Furthermore, if it is confirmed through subsequent detailed examinations that the secondary battery 2 is actually functioning normally, the performance of the vehicle 10 in moving can be restored by lifting the usage restrictions imposed on the secondary battery 2. Thus, it is possible to provide highly convenient control in preparation for a malfunction of the secondary battery 2 while the vehicle 10 is moving.

In addition, this embodiment has the same functions and advantages as in the first embodiment.

### (Ninth Embodiment)

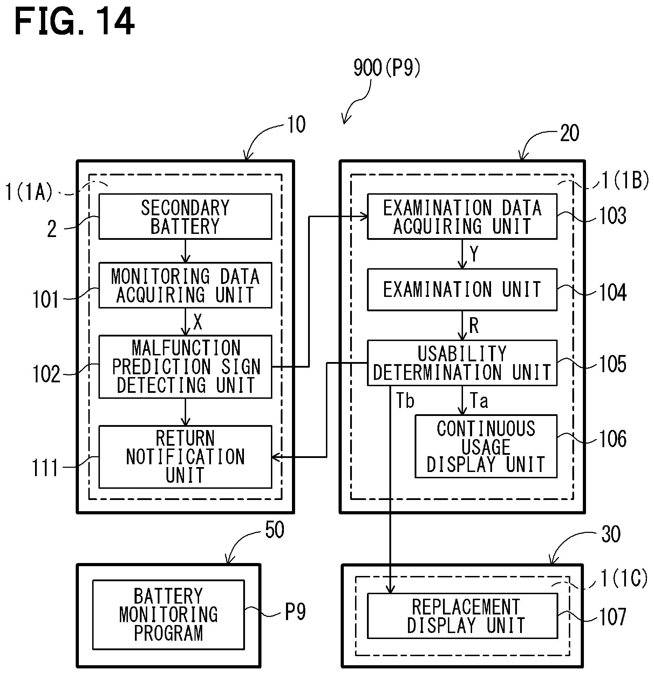

As shown in FIG. 14, a battery monitoring system 900 of the ninth embodiment differs from the battery monitoring system 100 of the first embodiment in that the battery pack of the vehicle 10 further includes a return notification unit 111. The function of each component of the battery monitoring system 900 is realized by a battery monitoring program P9. The battery monitoring program P9 is a program configured to cause the processors 1 (processors 1A, 1B, 1C) to realize a function of issuing a return encouragement notification that encourages the return of the secondary battery 2 when a malfunction prediction sign of the secondary battery 2 is obtained, and a function of withdrawing the return encouragement notification when the secondary battery is normal based on the examination result R of the battery characteristic, in addition to functions similar to those of the battery monitoring program P1 of the first embodiment. The battery monitoring program P9 is preferably recorded on the recording medium 50 in a readable manner as necessary.

The return notification unit 111 has both the function of issuing a return encouragement notification to encourage the return of the secondary battery 2 when the malfunction prediction sign detecting unit 102 acquires a malfunction prediction sign of the secondary battery 2, and the function of withdrawing the return encouragement notification when the secondary battery 2 is normal based on the examination result R of the battery characteristic made by the examination unit 104. If the battery pack including the secondary battery 2 is replaceable, the return notification unit 111 is preferably provided in the battery pack itself. When the replaceable battery pack is mounted on the vehicle, it is desirable to display the signal from the return notification unit 111 on the vehicle 10. This allows the user to check the return encouragement notification and its withdrawal on the battery pack, whether the battery pack is removed from the vehicle 10 or installed in the vehicle 10. When the battery pack is fixed, the return notification unit 111 may be provided in at least one of the vehicle 10 and the battery pack.

The other configuration is the same as that of the first embodiment.

According to the ninth embodiment, the user can check the return encouragement notification for the secondary battery 2 using the return notification unit 111 to recognize that there is a malfunction prediction sign for the secondary battery 2. Thus, the user can prepare to return the secondary battery 2. Furthermore, the user can then check that the return encouragement notification has been withdrawn using the return notification unit 111, and recognize that the detailed examination of the secondary battery 2 has shown that the secondary battery 2 is actually normal. This allows the user to promptly recognize information regarding a malfunction of the secondary battery 2.

In addition, this embodiment has the same functions and advantages as in the first embodiment.

Although the present disclosure has been described in accordance with the embodiments, it is understood that the present disclosure is not limited to such embodiments or structures. The present disclosure encompasses various modifications and variations within the scope of equivalents. In addition, various combinations and forms, as well as other combinations and forms that include only one element, more than one element, or fewer elements, are also within the sprit and the scope of the present disclosure. For example, the following embodiments can be implemented by applying the above-mentioned embodiments.

In the above-described embodiments, the usability of the secondary battery 2 is determined based on the examination result R of the battery characteristic of the secondary battery 2, and the examination results Ta and Tb are displayed. However, only the examination result R of the battery characteristic or the examination result R and the determination results Ta and Tb may be displayed without determining the usability of the secondary battery 2. When the usability of the secondary battery 2 is not determined, the program is sufficient if it causes the at least one processor 1 to realize at least the function of acquiring monitoring data X of the secondary battery 2 and the function of examining the battery characteristic of the secondary battery 2 based on the examination data Y when a malfunction prediction sign of the secondary battery 2 is acquired based on the acquired monitoring data X.

### <Display Program>

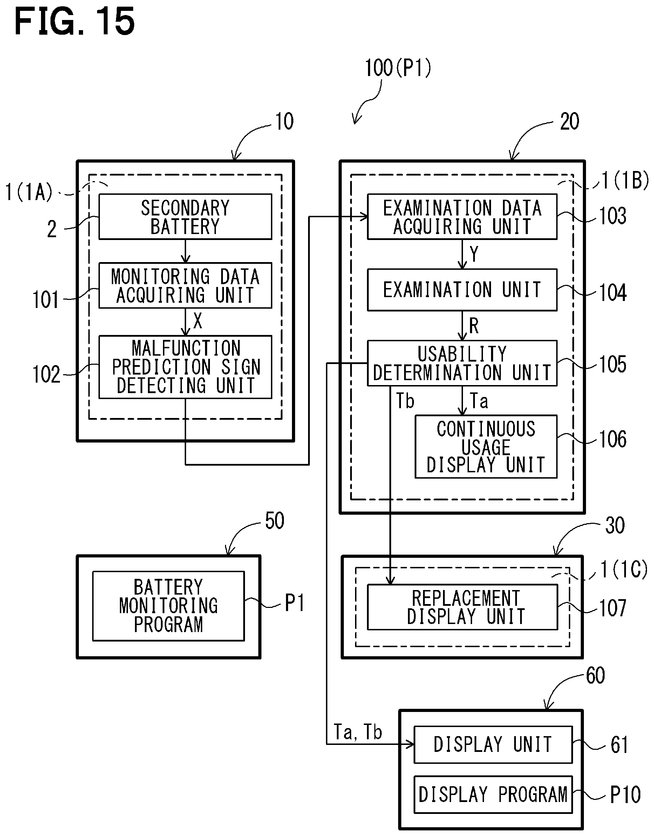

The battery monitoring program according to this embodiment includes at least a part of a display program P10 (see FIG. 15) which is described as a technical idea to be described later. Alternatively, the display program P10 may be separate from the battery monitoring program. The display program P10 is recorded in a non-transitory storage medium of at least one of the charging station 20 and the battery service center 30. The display program P10 displays information to the user on at least one of the continuous usage display unit 106 of the charging station 20 and the replacement display unit 107 of the battery service center 30.

In addition, the display program P10 may be downloaded from a cloud server or the like to a device 60 owned by the user, such as a desktop or notebook personal computer (PC), a tablet terminal, or a mobile terminal. The display program P10 may then display information to the user on the screen of the device 60. In this case, for example, a display unit 61 shown in FIG. 15 corresponds to a screen of the device 60. The display program P10 may be stored in a cloud server.

### [Technical Idea 1]

A display program (P10) configured to cause at least one processor (1) to display, on a display unit (61), a malfunction prediction sign of a secondary battery (2) and an examination result (R) of a battery characteristic of the secondary battery showing the malfunction prediction sign.

### [Technical Idea 2]

The display program as described in technical idea 1, configured to cause the at least one processor to display, on the display unit, at least one of a preliminary order for a replacement secondary battery that replaces the secondary battery showing the malfunction prediction sign and an official order for the replacement secondary battery that replaces the secondary battery that is determined to be unusable.

### [Technical Idea 3]

The display program as described in technical idea 2, configured to cause the at least one processor to display, on the display unit, at least one of a usage restriction of the secondary battery showing the malfunction prediction sign and a usage restriction lift of the secondary battery that is determined to be normal.

### [Technical Idea 4]

The display program as described in technical idea 3, configured to cause the at least one processor to display, on the display unit, at least one of a return encouragement notification of the secondary battery showing the malfunction prediction sign and a return encouragement withdrawal notification of the secondary battery that is determined to be normal.

## Claims

1. A battery monitoring program (P1, P2, P3, P4, P5, P6, P7, P8, and P9) configured to cause at least one processor (1) to:
obtain a malfunction prediction sign of a secondary battery (2); and
examine a battery characteristic of the secondary battery on obtaining the malfunction prediction sign of the secondary battery.

2. The battery monitoring program according to claim 1, further configured to cause the at least one processor (1) to
determine whether the secondary battery is usable based on an examination result (R) of the battery characteristic.

3. The battery monitoring program according to claim 1, further configured to cause the at least one processor (1) to:
instruct placement of a preliminary order for a replacement secondary battery to replace the secondary battery on obtaining the malfunction prediction sign of the secondary battery; and
instruct placement of an official order for the replacement secondary battery on determining that the secondary battery is not usable based on an examination result (R) of the battery characteristic.

4. The battery monitoring program according to claim 1, further configured to cause the at least one processor (1) to:
output a usage restriction instruction (Sa) to a battery controller (3) on obtaining the malfunction prediction sign of the secondary battery; and
output a usage restriction lift instruction (Sb) to the battery controller based on the secondary battery being normal according to an examination result (R) of the battery characteristic.

5. The battery monitoring program according to claim 1, further configured to cause the at least one processor (1) to:
issue a notification that encourages return of the secondary battery on obtaining the malfunction prediction sign of the secondary battery; and
withdraw the notification based on the secondary battery being normal according to an examination result (R) of the battery characteristic.

6. A recording medium configured to store, in a readable manner, the battery monitoring program according to any one of claims 1 to 5.

7. A battery monitoring system (100, 200, 300, 400, 500, 600 700, 800, 900) that monitors a secondary battery (2), the battery monitoring system comprising
an examination unit (104) configured to examine a battery characteristic of the secondary battery based on a malfunction prediction sign of the secondary battery being obtained.

8. The battery monitoring system according to claim 7, further comprising
a usability determination unit (105) configured to determine whether the secondary battery is usable based on an examination result (R) of the battery characteristic examined by the examination unit; and
a usability display unit (106, 107) configured to display a determination result (Ta, Tb) determined by the usability determination unit.

9. The battery monitoring system according to claim 7, further comprising
a preliminary order unit (108) configured to instruct placement of a preliminary order for a replacement secondary battery to replace the secondary battery based on a malfunction prediction sign of the secondary battery being obtained; and
an official order unit (109) configured to instruct placement of an official order for the replacement secondary battery based on the secondary battery being determined not to be usable according to an examination result (R) of the battery characteristic examined by the examination unit.

10. The battery monitoring system according to claim 7, further comprising an instruction output unit (110) configured to output:
a usage restriction instruction (Sa) to a battery controller (3) based on the malfunction prediction sign of the secondary battery being obtained; and
a usage restriction lift instruction (Sb) to the battery controller based on the secondary battery being normal according to an examination result (R) of the battery characteristic examined by the examination unit.

11. The battery monitoring system according to claim 7, further comprising a return notification unit (111) configured to:
output a notification that encourages a return of the secondary battery based on the malfunction prediction sign of the secondary battery being obtained; and
withdraw the notification based on the secondary battery being normal according to an examination result (R) of the battery characteristic examined by the examination unit.
